# EUROPEAN PATENT APPLICATION

(11) **EP 2 287 356 A1**
(43) Date of publication of application: **23.02.2011**
(21) Application number: 09167005.9
(22) Date of filing: 31.07.2009
(51) Int. Cl.: C23C 14/34, H01J 37/34

(54) **Sputter target, method and apparatus for manufacturing sputter targets**

(71) Applicant: Bekaert Advanced Coatings NV., 9800 Deinze (BE)
(72) Inventor: Aps, Freddy, 9120, Haasdonk (BE); Carvalho, Nuno, 9051, Sint-Denijs-Westrem (BE)
(74) Representative: Bird, William Edward

(57) **Abstract**

A sputter target (12) as well as a method and an apparatus (10) for manufacturing such kind of a sputter target (12) is described, wherein the sputter target (12) for use as a material source in a sputtering process comprises a mainly tubular or cylindrical carrier (22) for supporting at least one layer, a target layer (32) manufactured by direct chill casting for providing sputter material (34) supported by the carrier (22), wherein in radial direction at least 80% of the grains of the sputter material (34) comprises gains having a diameter differing within a range Δd of Δd ≤ 40 µm, particularly Δd ≤ 30 µm, preferably Δd ≤ 20 µm and most preferred Δd ≤ 10 µm. Due to the direct chill casting method the sputter material (34) is very homogeneous both in radial direction and circumferential direction. This leads to improved sputter performance during the sputtering process and this for significantly increased target layer thicknesses (32).

## Description

### Technical field of the invention

The present invention relates to sputter targets. The present invention further relates to a method and an apparatus for manufacturing such kind of a sputter targets. Sputter targets can be used as source for thin coatings in sputter processes like magnetron sputtering, for example.

### Background of the invention

From WO 2005/090631 A1 it is known to manufacture a sputter target, which can be used as source for thin coatings in a sputter process, by thermally spraying sputter material onto a tubular carrier. In a thermal spray process superheated molten or semi-molten particles are projected at high velocities onto the proportionally much colder carrier tube and solidify rapidly in a typical splat-like microstructure. Though thermal spraying offers a lot of benefits as a manufacturing route for rotating cylindrical targets, e.g. processing flexibility, it also has some inherent drawbacks such as a relatively high porosity level in the coating layer and a limitation in layer thickness. This layer thickness limitation is caused by the gradual increase of internal material stresses during layer build-up, resulting from quenching stresses within the grains and thermal stresses due to an increasing target surface temperature. Since the sputtering process is carried out under high vacuum conditions, it is time consuming and expensive to stop the sputtering process, replace the sputter target and continue the sputtering process. Hence there is a permanent need for sputter targets of increased thickness, beyond the limits of current thermal spraying technology. There is a continuous market striving towards higher production throughputs of sputtered product, which translates into higher sputter power and heat load on the target's surface. This heat load is removed from the sputter chamber mainly via water-cooling inside the target's carrier tube, which is strongly dependent upon the overall thermal conductivity of the sputter target. Generally the thermal conductivity of thermally sprayed metallic sputter targets is not optimal due to the higher porosity and oxygen impurity levels.

US 6,719,034 describes a process for producing a tube target for cathode sputtering plants, comprising the steps of: producing a metallic inner tube (target holder) of a first material with a first melting point of Tₛ₁ ≥ 900 K; producing a metallic outer tube (target) that concentrically surrounds the inner tube and is made of a second material with a second melting point of Tₛ₂ ≥ 800 K, the tubes being produced so that an inside diameter of the outer tube and an outside diameter of the inner tube are proportioned in such a way that the two tubes fit together tightly and are mechanically firmly joined, the step of producing the outer tube including forming the outer tube by casting the second material in a molten state in a heated, vertical, cylindrical permanent mould, the inner tube forming a heated mandrel for the cylindrical mould; and, after a space between the mould and the inner tube has been filled with the molten second material, cooling the outer tube from inside to outside and from bottom to top by actively developing a first, radial thermal gradient between the inner tube and the mould and a second thermal, longitudinal gradient between a bottom and a top of the mould.

### Summary of the invention

It is an object of the present invention to provide an alternative sputter target, especially a magnetron sputter target and further a method and an apparatus for manufacturing such kind of a sputter target.

An advantage of embodiments of the present invention is that the coating layer on the sputter target can have increased thickness with improved microstructural homogeneity, beneficial in the sputtering process.

The above objective is accomplished by a sputter target, a method and an apparatus, according to the present invention, as illustrated in the accompanying claims.

A sputter target, especially a magnetron sputter target, according to the invention for use as a material source in a sputtering process, can comprise a mainly tubular or cylindrical carrier for supporting at least one target layer for providing sputter material supported by the carrier, wherein the target layer is a direct chill cast layer. Preferably, the sputter target further comprises a bonding layer between the carrier and target layer.

It is found, that it is possible to manufacture, particularly by use of a direct chill casting process, a sputter target with a very homogeneous composition of the sputter material. It is also found, that it is possible to manufacture, particularly by use of a direct chill casting process, a sputter target with a fine cast grain structure.

The invention relates in some embodiments to a cathode in the form of a cylindrical or tubular laminated metallic structure for use in a plasma sputtering unit, comprising at least two and preferably three (i.e. metal containing) moieties (entities) bonded to each other and preferably having mutually differing coefficients of thermal expansion.

A first moiety (22) is preferably manufactured from an alloy steel , e.g. from the 300 series stainless steel series e.g. AISI (American Iron & Steel Institute) 304L, as a carrier for the laminated structure, but can also be an aluminium, copper or nickel based alloy. This substrate or carrier is also named the backing tube. The thickness of the backing tube can be, for example, 4 mm. The carrier is particularly preferably rotationally symmetric. This leads to a rotatable cylindrical sputter target. The carrier is preferably tubular, so that the carrier can be easily cooled from the inside for instance by water during processing.

Optionally surface activating pre-treatments of the backing tube prior to the application of a second layer, e.g. grit blasting and/or fluxing, can be used to promote bonding and wetting behaviour by the second (intermediate) layer.

A second moiety (24), deposited on the outside surface of the first moiety, is a metallic layer that will act as a bond layer between the first and third moiety. The thickness of this bond layer can be quite thin, for example less than 1 mm, and is sufficient for the formation of an adequate diffusion barrier against the formation of brittle phases between, e.g. the iron from a stainless steel layer and an alloy of the third moiety (target layer). The bonding layer may consist of one layer or of several sub-layers that may comprise mainly zinc, nickel, copper, aluminum, indium, tin or a combination hereof e.g. a galvanizing layer of zinc or a thin electrolytic nickel layer contiguous with the steel carrier overcoat with a 20-50 µm thick copper layer. Preferably these elements diffuse at least partially into each other during the manufacturing process and sufficiently wet the first moiety (substrate) to ensure good bonding during the manufacturing process of the third moiety.

The thin layer may also be sufficiently ductile to bridge the thermal mismatch stresses that occur during both the manufacturing process of the cathode and its application in a sputter process and to avoid the formation of cracks due to the thermal mismatch in the layered structure. In sputter applications a uniform electrical and heat-conduction surface is preferably ensured at all times.

The average expansion coefficient of the bond layer lies between that of the first alloy and the third coating. The composition of this intermediate ductile layer can in general be adapted in such a way that it promotes beneficial diffusions from moiety 1 to 2 an/or 2 to 1 and simultaneously forms a barrier between unwanted diffusions from layer 1 to 3 and/or vice versa.

Various manufacturing methods for the at least one bonding layer can be used, e.g. galvanizing,_thermal spray, electro- or electroless deposition or soldering and casting. Optionally surface activating pre-treatments of the second layer prior to the application of the third layer, e.g. grit blasting and/or fluxing, can be used to promote bonding and wetting behaviour by the second layer.

A third outer moiety (32), the target layer, deposited on the second moiety (bonding layer), will act as a layer of sputterable material during a sputter deposition process. Compared to the first moiety, the substrate, and second moiety, the bonding layer this coating layer is quite thick, preferably thicknesses from 6 to 20 mm.

A sputter target, especially a magnetron sputter target, according to the invention, for use as a material source in a sputtering process, can also comprise a mainly tubular or cylindrical carrier for supporting at least one layer, a target layer for providing sputter material supported by the carrier, wherein in a radial direction at least 80% of the grains of the sputter material have a diameter within a range Δd, Δd being ≤ 100 µm, particularly ≤ 75 µm, preferably ≤ 60 µm and most preferred ≤ 40 µm.

The grains of most of the sputter material have preferably substantially the same diameter. It is even possible that Δd is ≤ 25 µm or even ≤ 10 µm. The average grain size diameter can be determined by any method according to ASTM E-111-96, which includes the comparison procedure (see section 10), the planimetric (or Jeffries') procedure (see section 11) and the intercept procedures (see section 12). The intercept procedures include the Heyn intercept procedure (see section 13) and the circular intercept procedures (see section 14), which include the Hilliard single-circle procedure (see section 14.2) and the Abrams three-circle procedure (see section 14.3). The average diameter in mm is the square root of (1 mm²/number of grains in cross section of that one mm²). It is understood that the grains of the sputter material are given by the dendritic primary phases.

Due to the substantially same diameter of the grains of the sputter material, the sputter material is very homogeneous both in the radial direction and longitudinal (circumferential) direction. This leads to improved sputter behaviour of the target during the sputtering process. The improved homogeneity and small grain sizes throughout the radial thickness, together with a high thermal conductivity of the target layer, will ensure that this stable behaviour is maintained throughout the gradual reduction of the thickness of the target layer during the sputtering process. Undesirable effects due to local changes of the properties of the sputter material, such as e.g. arcing, are strongly reduced and lead to improved homogeneity in the sputter deposited layer on the end product. Due to the higher target thickness it is possible to use the sputter target thereby provided for a significantly longer time in a sputtering process. This leads to a longer operating time per sputter target, which in turn enables longer sputter coating runs without the need to stop the sputtering process to replace the sputter target.

The grains are preferably equiaxed (equiaxial) in shape i.e. whether measuring in the radial, longitudinal or circumferential direction does not significantly alter the average intersected length of the grains.

The sputter material is particularly a metal or metal alloy preferably having a melting point below 1000 K, e.g. comprising Zn, Al, Sn, In, Cu or Ga, with alloys of zinc and tin, copper and indium, copper and gallium and copper, indium and gallium being preferred. The sputter material is preferably of high purity, this means a purity of preferably at least 99 mol%, more preferably at least 99.9mol% and most preferably at least 99.99 mol% of only one metal or of each metal of an alloy. For example a sputter material comprising 99.9 mol% of a Zn-Sn alloy with 15 mol% Sn is used for the target layer of the sputter target.

In a preferred embodiment at least 85%, particularly at least 90% and preferably at least 95% of the grains of the sputter material comprises a grain size diameter differing within the range Δd. Due to the increased amount of sputter material grains of mainly the same diameter the homogeneity of the sputter material is further increased.

Particularly the target layer comprises in radial direction a layer thickness s of 4.0 mm ≤ s ≤ 30.0 mm, particularly 6 mm ≤ s ≤ 25.0 mm, preferably 9.0 mm ≤ s ≤ 20 mm and most preferably 12.0 mm ≤ s ≤ 18.0 mm. Such comparatively thick target layers can be produced with the necessary homogeneity by direct chill casting. The chosen thickness of the target layer is still small enough that the temperature in the target layer can be influenced during the application of the sputter material to the carrier. Particularly by cooling a mainly liquid target layer from the outside for instance by a direct chilling water-jet impinging directly on a solidified outer shell of the target layer, a fast cooling is possible promoting small grain sizes and homogeneity of the solidified sputter material. In order to further improve the speed of the cooling and the promotion of smaller grain sizes, cooling the mainly liquid target layer from the inside via the carrier in addition to the cooling from the outside may be used. The heat conductivity of the sputter material at such chosen thicknesses allows comparatively low temperature differences in radial direction prior and during the solidification of the sputter material. A high amount of homogeneity of the sputter material is thereby ensured.

In a preferred embodiment at least 80%, particularly 85%, preferably at least 90% and most preferred at least 95% of the grains of the sputter material in radial direction have a grain size with an average diameter d of d = 60 µm ± Δd, particularly d = 50 µm ± Δd, preferably d = 40 µm ± Δd and most preferred d =30 µm ± Δd, wherein Δd < d is given. Due to the comparatively small grain sizes very homogeneous conditions of the target layer are given. It is to be understood, that at larger grain sizes Δd can be greater than at smaller grain sizes, so that the lower limit of a diameter d cannot be negative.

Preferably a bonding layer for bonding the target layer to the carrier is provided between the carrier and the target layer. The bonding layer can be provided by galvanizing, electro- or electroless processing or thermal spraying the carrier particularly by one or more sub-layers comprising mainly zinc, nickel, copper, aluminum, indium, tin or a combination thereof. The thermal conductivity of the bonding layer is particularly between the thermal conductivity of the carrier and the target layer. The composition and/or properties of a suitable bonding layer, which can be arranged between the carrier and the target layer, are disclosed in EP 0 586 809A1 and WO 2004/074541A1, which are herewith incorporated by reference. Due to the bonding layer the sputter material may adhere better to the carrier, consequently improving the overall thermal conductivity of the sputter target.

Particularly an axial length L, where the target layer is a continuous material, is 0.5 m ≤ L ≤ 10.0 m, particularly 1.0 m ≤ L ≤ 7.0 m, preferably 2.0 m ≤ L ≤ 5.0 m and most preferred 3.0 m ≤ L ≤ 4.0 m. The target layer can be manufactured by casting in one pour. Discontinuities in axial direction can be prevented over a length of several meters or more. In the case of discontinuities, an upper axial end and/or a lower axial end can be cut away from a cast sputter target to ensure a continuous homogeneity of the target layer of the sputter target in an axial direction. Inhomogeneous parts due to transient and unsteady conditions at the beginning and end of the casting process for manufacturing the target layer can be prevented in the ready-to-use product.

The invention further relates to a method for manufacturing a sputter target, especially a magnetron sputter target, which particularly can be designed as previously described, wherein a direct chill casting process is applied for providing a mainly tubular or cylindrical carrier with a target layer for providing sputter material. Preferably, a casting speed v_{c} of the relative movement of the stationary direct chill cast mould applying liquid sputter material to the carrier tube moving downward and a level hₗ of the liquid sputter material inside the mould in axial direction of the carrier is chosen such that at least 80% of the grains of the sputter material in a solidified state in radial direction have a diameter differing within a range Δd, Δd being ≤ 100 µm, particularly ≤ 75 µm, preferably ≤ 60 µm and most preferably ≤ 40 µm.

It is found, that it is possible to manufacture, particularly by use of a direct chill casting process, a sputter target with a very homogeneous composition of the sputter material. The grain sizes of most of the sputter material in radial and circumferential direction are mainly at the same diameter. It is even possible that Δd is ≤ 30 µm or even ≤ 20 µm. The diameter is determined as previously described. Due to the mainly same diameter of the grains of the sputter material, the sputter material is very homogeneous both in radial direction and circumferential direction. This leads to improved sputter behaviour of the target during the sputtering process. The Improved homogeneity and grain sizes with small diameters throughout the radial thickness, together with a high thermal conductivity of the target layer, will ensure that this stable behaviour is maintained throughout the thickness reduction of the target layer during the sputtering process. It is possible to significantly increase the thickness of the target layer without negatively affecting the sputtering process stability.

Direct Chill casting (DC casting) is a primary means for the production of solid extrusion billets and solid rolling ingots from a wide range of aluminum wrought alloys. At the direct chill casting the melt is poured from the top in an opened, relatively short particularly water-cooled mould. The mould is preferably copper-based and preferably incorporates graphite. This mould can be closed at the beginning by a dummy block connected with a mechanical or hydraulic lowering system. After the melt level in the mould reaches a certain level, the dummy block can be lowered and the solid part of the billet or the ingot is extracted downward with respect to the mould whilst melt flow rate and casting speed are adjusted so that melt level in the mould remains mainly constant. As soon as the solid shell emerges from the bottom part of the mould, a liquid cooling spray or film is applied to the surface (direct cool). This rapid cooling_effect is obtained, when a cylindrical or tubular target layer is cast onto a carrier for manufacturing a rotatable cylindrical sputter target. Since it is possible to extract the heat mainly through the solid part of the casting, and optionally also from the inside via the carrier, a flatter solidification profile can be provided. This leads to a considerably reduced centre line segregation and an increased density of the central portion. The mechanical properties of the target layer are improved and a fine and homogeneous microstructure given.

Particularly the sputter material is liquid-jet cooled at the level and/or below the mould, wherein a cooling area, where the liquid-jet meets the sputter material, and a mass flow of a used liquid, particularly water, is chosen with respect to the intended grain sizes of the sputter material. The cooling of the sputter material is adjusted such that the grain sizes of the sputter material close to the outside do not differ very much from the grain sizes of the solidified sputter material close to the middle of the target layer. As a result of the cooling a solidified outer wall of the sputter material can be provided, which is thick enough so that no liquid sputter material can bleed out through the solidified wall below the mould. At the same time the cooling is adjusted such that the solidified wall is not too thick, so that a flat solidification line over mainly the whole thickness of the target layer is realised. Preferably a temperature Tₗ of the liquid sputter material filled into the mould and/or a Temperature T_{ci} of the carrier on the inside is chosen with respect to the intended grain sizes of the sputter material. The temperature T_{ci} of the carrier is adjusted such that the grain sizes of the sputter material close to the inside do not differ very much from the grain sizes of the solidified sputter material close to the middle of the target layer. This adjustment preferably also ensures that the intended or expected bonding quality with the target layer is achieved. Similarly the temperature Tₗ of the liquid sputter material is chosen with respect to the intended or expected solidification characteristics of the sputter material. This temperature is preferably also chosen with respect to the intended or expected bonding quality. The temperature Tₗ should be sufficiently above the melting point that the liquid sputter material is easily castable and has enough time inside the mould that the liquid sputter material is mainly not in motion before solidification. In addition the temperature Tₗ of the liquid sputter material can be such close to the melting point that the solidification occurs after a comparatively short period of time without affecting the intended grain size distribution of the solidified sputter material. The temperature Tₗ of the liquid sputter material is particularly chosen with respect to the intended level hₗ of the liquid sputter material inside the mould, so that a too fast and a too slow solidification of the sputter material is prevented by safeguarding the level of the liquid sputter material inside the mould. The solidification of the liquid sputter material is very rapid preferably < 100s from pouring temperature to solidification on the substrate representing a temperature decrease of ca. 100°C, with < 70 s being particularly preferred and < 60 s being especially preferred.

Particularly the carrier is coated with a bonding layer, comprising of one or more sub-layers, for bonding the target layer to the carrier, and the thickness of the bonding layer in radial direction is chosen such that at given casting speed v_{c} and level hₗ of the liquid sputter material a residual thickness of the bonding layer remains present in solidified state under the sputter material. The thickness of the bonding layer in radial direction is preferably also chosen such that at least one of the sub-layers has metallically bonded to the target layer. The thickness of the bonding layer is particularly chosen such that the bonding layer may be partially melted by the liquid sputter material or may be metallically bonded to neighbouring target layer and carrier. This may even increase the bonding of the target layer to the bonding layer. But it is preferred that not so much of the bonding layer is melted that the purity of the sputter material in radial direction is significantly affected at a given temperature Tₗ of the liquid sputter material in the mould.

When the sputter material is at least 80wt% aluminium the casting speed v_{c} is preferably in the range 1 mm/min ≤ v_{c} ≤ 30 mm/min, particularly 2 mm/min ≤ v_{c} ≤ 20 mm/min, preferably 3 mm/min ≤ v_{c} ≤ 10 mm/min and most preferably 4 mm/min ≤ v_{c} ≤ 5 mm/min.

The preferred casting speed with other materials can be calculated using the ratio of the different heat capacities cₚ. The adjusted casting speed can be calculated by v_{c}(new material) = v_{c}(AI) · cₚ(AI)/cₚ(new material). For such casting speeds or castings speeds adapted to metals or metal alloys, which differ from aluminium, a fine and homogeneous microstructure of the solidified sputter material is expected.

Particularly the level hₗ of the liquid sputter material is in the range 40 mm ≤ hₗ ≤ 400 mm, preferably 60 mm ≤ hₗ ≤ 320 mm, particularly preferably 80 mm ≤ hₗ ≤ 280 mm and most preferably 100 mm ≤ hₗ ≤ 240 mm. This level is particularly preferred when the sputter material is mainly aluminium. For such levels hₗ of the liquid sputter material a fine and homogeneous microstructure of the solidified sputter material is to be expected.

Preferably an outside of the liquid sputter material is cooled at such a cooling rate that a temperature difference of ΔT_{c} = 100 K is reached after a cooling time t_{c} in the range of 20 s ≤ t_{c} ≤ 150 s, particularly 30 s ≤ t_{c} ≤ 100 s, preferably 40 s ≤ t_{c} ≤ 70 s and most preferred 50 s ≤ t_{c} ≤ 60 s. ΔT_{c} is the difference between the temperature T_{c} of the outside of the liquid sputter material at any time of the cooling process (t = 0) and the temperature T_{c} after the cooling time (t = t_{c}). This cooling rate allows a fast cooling without introducing inhomogeneities into the solidifying sputter material. Further, particularly for aluminum, a fine and homogeneous microstructure of the solidified sputter material can be expected.

The invention further relates to an apparatus for direct chill casting, particularly for carrying out the above mentioned method, wherein the apparatus comprises at least a support device for supporting a mainly tubular or cylindrical carrier for supporting at least the total final target, a mould for receiving a liquid sputter material and casting the liquid sputter material onto the carrier, wherein the mould is adapted to provide at least a level hₗ of the liquid sputter material inside the mould in axial direction of the carrier, a melting furnace and melt launder to feed the molten metal into the pouring basin above the mould, an optional inert gas or vacuum system for protecting the melt from oxidation, ,an optional "hot top" insulation system for the mould and pouring basin, a "level pour" system for ensuring constant liquid level during the direct chill casting process, and a controller for controlling a casting speed V_{c} of the relative movement of the carrier to the mould and the level hₗ of the liquid sputter material such that at least 80% of the grains of the sputter material comprises in solidified state in radial direction grains having a diameter differing within a range Δd of Δd ≤ 100 µm, particularly Δd ≤ 75 µm, preferably Δd ≤ 60 µm and most preferred Δd ≤ 40 µm. The diameter is determined as previously described. Using this apparatus a sputter target as previously described can be manufactured. Due to the substantially similar diameter of the grains of the sputter material, the sputter material is very homogeneous both in radial direction and longitudinal (circumferential) direction. This leads to improved sputter behaviour of the target during the sputtering process. The improved homogeneity and small grain sizes throughout the radial thickness, together with a high thermal conductivity of the target layer, will ensure that this stable behaviour is maintained throughout the gradual reduction of the thickness of the target layer during the sputtering process. Particularly the support device can move relative to the mould with casting speed v_{c}.

Particularly the support device is adapted to align the carrier vertically, wherein the maximum angle αₘₐₓ between a middle axis of the carrier and vertical direction is αₘₐₓ ≤ 0.03°, particularly αₘₐₓ ≤ 0.015°, preferably αₘₐₓ ≤ 0.01 ° and most preferred αₘₐₓ ≤ 0.005°. Due to the comparatively small tolerance of the vertical alignment, very long sputter targets of several meters can be cast in one pour.

The present invention also includes a magnetron-sputtering device including a sputtering target as disclosed above.

The present invention also includes a method of driving a magnetron sputtering device including the step of rotating a cylindrical sputtering target as disclosed above in a plasma such as to sputter material to a substrate.

### Brief description of the drawings

Fig. 1 is a schematic cross sectional view of an apparatus for casting sputter targets by a direct chill casting process according to an embodiment of the present invention.
Fig. 2 schematically shows a direct chill casting process according to an embodiment of the present invention.
Fig. 3 shows a rotatable cylindrical sputter target according to an embodiment of the present invention.
Fig. 4 shows the principle of the tripod system used to align the backing tube in vertical position concentric with the mould axis according to an embodiment of the present invention.
Fig. 5 shows a cross-section of the device of Fig. 2 across the pouring basin (3) and perpendicularly to the backing tube walls according to an embodiment of the present invention.
Fig. 6 shows an alternative melt protection method against oxidation using vacuum degassing according to an embodiment of the present invention.

### Detailed description of the drawings

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the sum of the technical teaching of the invention, the invention being limited only by the terms of the appended claims.

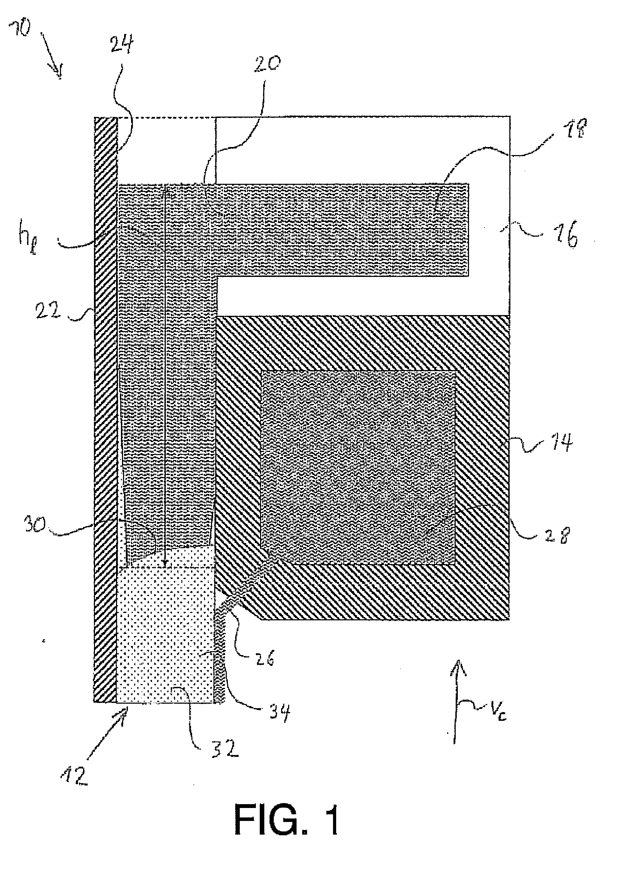

As illustrated in Fig. 1 an apparatus 10 for direct chill casting of sputter targets 12 comprises a mould 14. The mould 14 comprises at its upper end a hot top 16. The hot top 16 provides a pouring basin 18 into which liquid sputter material 20 can be filled. This liquid sputter material 20 is preferably protected from oxidation by means of an inert gas cover. The liquid sputter material 20 is applied to a cylindrical carrier 22, wherein the cylindrical carrier 22 can be coated with a bonding layer 24 that can comprise of one or more sub-layers. The liquid sputter material 20 comprises a level hₗ between the lowest liquid point and the highest liquid point in vertical direction. Due to the hot top 16 the liquid sputter material 20 is kept liquid in the upper regions and a wetting along mainly the whole height of the liquid sputter material 20 is provided.

The liquid sputter material 20 is cooled by a water-jet 26 fed from a water supply 28 of the mould 14. The liquid sputter material 20 can be further cooled from the inside of the carrier 22 for example by water cooling.. Due to the cooling the liquid sputter material 20 solidifies with a comparatively flat solidification front 30 and provides a target layer 32, which comprises a fine and homogeneous microstructure, wherein the grains of the solidified sputter material 34 are particularly small and have substantially similar diameters in the radial and longitudinal (circumferential) direction.

For providing a continuous growth of the target layer the cylindrical carrier 22 with solidified target layer 32 moves downwards with respect to the mould 14 with a relative casting speed v_{c}. The liquid sputter material 20 is supplied to the pouring basin with such a mass flow that the level hₗ is substantially maintained.

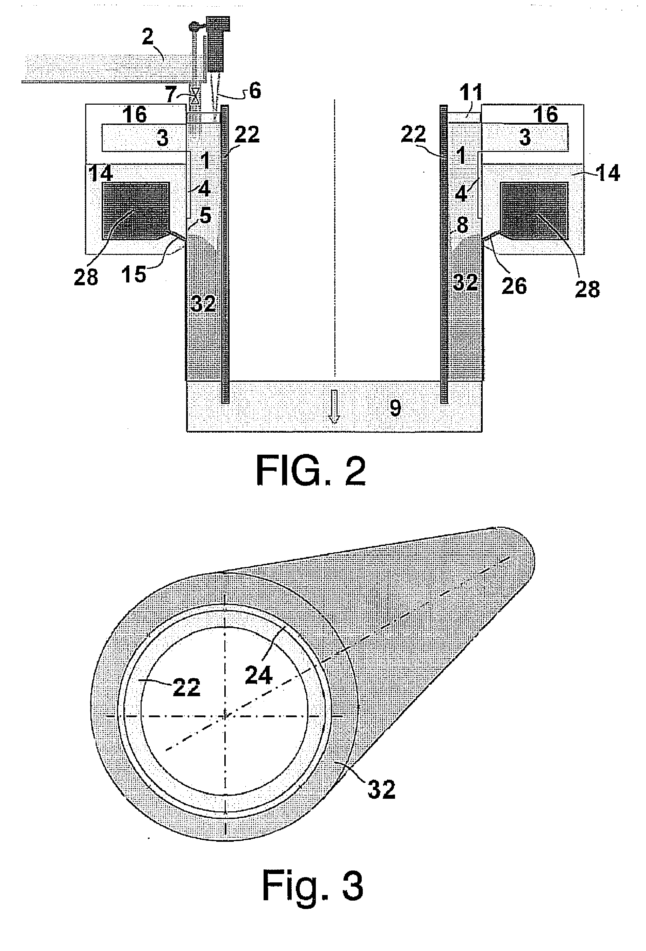

Figure 2 schematically shows a direct chill casting process according to an embodiment of the present invention. The apparatus used for performing the chill casting process comprises a melt furnace (not shown) connected to a top pouring basin (3) via a launder (2). The top pouring basin (3) is connected to a direct chilling (DC) mould (14). A hot top (16) is optionally present, insulating a top part of the direct chill mould (14). An insulating liner (4) is present in the inside of an upper part of the mould down to a desired length. A metal level detector (6) is present for maintaining a liquid metal level in the pouring basin (3) constant. The metal level detector controls a stopper valve (7) present between the launder (2) and the pouring basin (3). A cooling medium (28) is present within the mould (14). The cooling medium outputs via a duct (15) and spray nozzles (not shown) in the direct chill mould. A base plate or stool cap (9) is present at the bottom side of the direct chill casting mould, closing the said mould. The stool cap (9) is connected to a lowering system (not shown). A pit (not shown) filled with a cooling medium is optionally present for further cooling the lowered newly formed target.

In operation, a melt (1) constituting the third layer (32) of the rotating cylindrical sputter target is brought from the melt furnace (not shown) via the launder (2) and poured in the top pouring basin (3) spilling in the opened liquid-cooled direct chill mould (14). The hot top (16) reduces undesired solidification of the melt (1) on the top part of the mould insulated therewith.

In the pouring basin (3), the liquid is held at a constant level by means of the metal-level detector (6) controlling the stopper valve (7) and a feedback system controlling the melt furnace (not shown).

The melt's primary functions are providing the necessary feedstock material for the outer coating layer (32) and to compensate continuously for the material shrinkage that occurs during the subsequent solidification process. Additionally the hot melt has the advantageous function of locally pre-heating the outer surface of the bond layer (layer 24 in fig. 3). This preheating creates ideal interfacial temperature and wetting conditions for achieving a good metallic bonding in the subsequent casting solidification.

At the beginning of the casting process the direct chill casting mould is closed at the bottom by a base plate or stool cap (9) connected to a mechanical or hydraulic lowering system. The sputter target's backing tube (22), guided downwards concentrically inside the mould and held at its bottom end by a base plate, creates an annular shape of the liquid in direct contact with the bond layer on the backing tube.

After the melt level in the chilled mould reaches a certain level, the base plate (9) is lowered and the bonded assembly of backing tube and solid coating material, is extracted downward whilst the melt flow rate and the casting speed are adjusted so that the melt level in the mould remains constant.

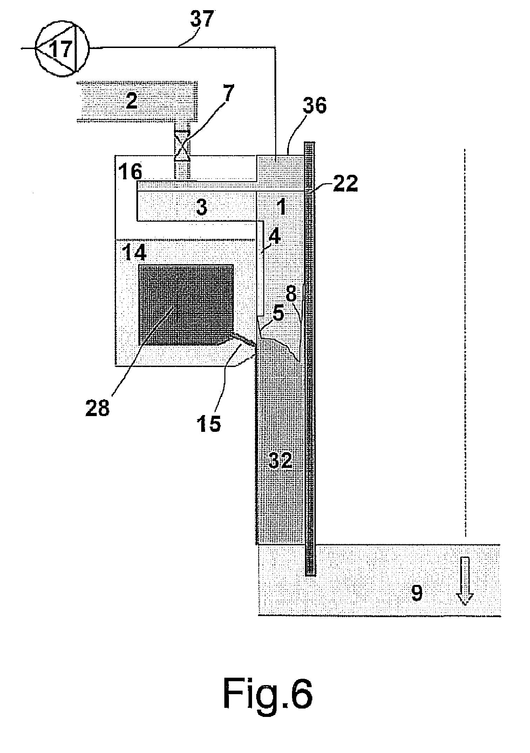

In Fig. 2, an inert gas cover (11) was used to protect both the melt and its interface with the substrate to suppress oxidation. In an alternate set-up of the direct chill casting system the liquid metal and sputter target is kept under primary vacuum conditions to avoid oxidation and to ease degassing of entrapped gases in the solidifying material (see Fig. 6).

The cooled mould provides a first thermal gradient with cooling from the mould in the direction of the backing tube. An insulating liner (4) in the inside of the upper mould part extends the hot top to the desired length, which is a function of the materials being coated. Nearly simultaneously two thin solid shells are formed: one at the interface with the water-cooled mould (5), a second thin shell is formed on the outside surface of the bond layer (8). Hot may be made of thermally insulating refractory materials.

As soon as the outer solid shell on the mould side emerges from the bottom part of the mould, water sprays (26) impinge directly on the outer shell surface, hence the term "Direct Chill" casting. This impingement drastically increases the rate at which the coating layer is cooled over the initial cooling rate in the chilled mould. The lowering of the sputter target outside the mould will cause a second directional cooling from the target bottom to the top. Draughts of air or other gases, which can impact the surface of the cooling coating are preferably excluded. Cooling can be further intensified by lowering the sputter target assembly into a pit filled with water.

As soon as the desired target length is reached, the casting is stopped.

The initial local pre-heating temperature of the backing tube is controlled by both the melt temperature and the residence time of the tube section in contact with the liquid in the pouring basin. Required residence time is dependent upon the heat flow properties of the target assembly, which - given the thin bonding layer - are mainly function of the substrate's thermal conductivity and weight. Residence time is controlled by adapted height of the hot top system and by control of the casting speed during casting.

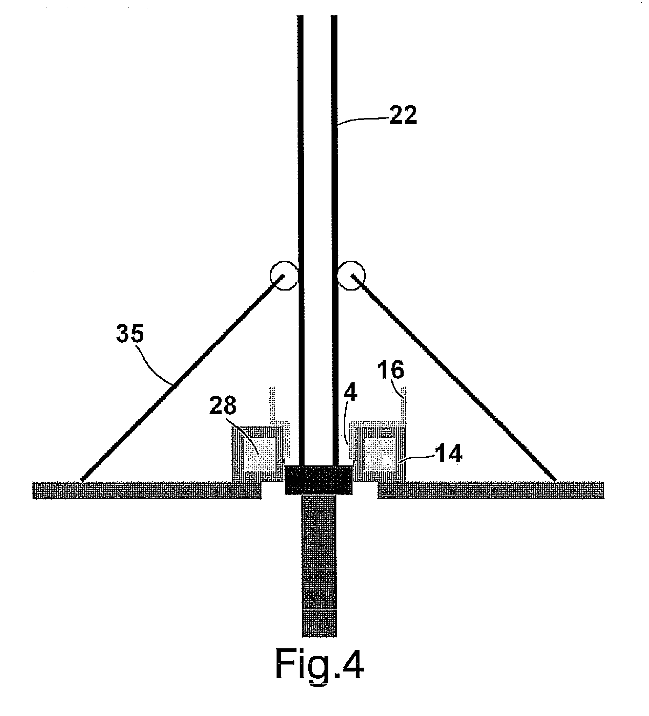

Figure 4 schematically represents the tripod system used to align the backing tube (22) in vertical position concentric with the mould axis. Two of the tripod pods (35) are represented.

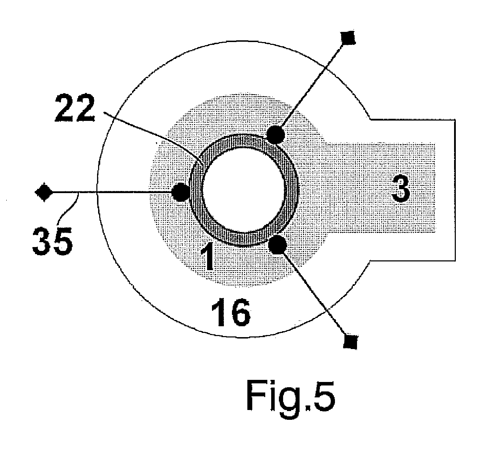

Fig. 5 is a cross-section of the device of Fig. 2 across the pouring basin (3) and perpendicularly to the backing tube walls. At the centre of Fig. 3, the backing tube (22) is represented surrounded by the melt (1) spilled out of the pouring basin (3). The ensemble consisting of the backing tube (22), the melt (1) and the pouring basin (3) is thermally isolated by the hot top (16). The tripod system of Fig. 4 is represented by its three pods (35).

Fig. 6 schematically shows a direct chill casting process according to an embodiment of the present invention including vacuum degassing of the melt. The apparatus used comprises a melt furnace (not shown) connected to a top-pouring basin (3) via a launder (2). The top-pouring basin (3) is connected to a direct chilling (DC) mold (14). A hot top (16) is optionally present, insulating a top part of the direct chill mold (14). An insulating liner (4) is present in the inside of an upper part of the mold down to a desired length. A metal level detector (6) (not shown, see Fig. 2) is present for maintaining a liquid metal level in the pouring basin (3) constant. The metal level detector controls a stopper valve (7) present between the launder (2) and the pouring basin (3). The pouring basin is isolated from the room environment by a closing lid (36) with a cut out hole to allow the backing tube (22) to pass and wit a connection for vacuum piping (37) leading to a primary vacuum pumping system (17).

A cooling medium (28) is present within the mold (14). The cooling medium outputs via a duct (15) and spray nozzles (not shown) in the direct chill mold. A base plate or stool cap (9) is present at the bottom side of the direct chill-casting mold, closing the said mold. The stool cap (9) is connected to a lowering system (not shown). A pit (not shown) filled with a cooling medium is optionally present for further cooling the lowered newly formed target.

In Figure 3, a rotatable cylindrical sputter target according to an embodiment of the present invention is shown. It comprises three concentric layers. An inner layer (22) is a backing tube serving as a carrier or substrate for the two other layers. A second layer (24) is contacting the outside surface of the first layer (22). The second layer (24) serves as a bonding layer between the first layer (22) and the third layer (32). A third layer (32) is contacting the outside surface of the second layer (24) and is present at the outside of the rotatable cylindrical sputter target. The third layer (32) is the target coating layer.

In a further aspect, the present invention relates to a magnetron sputtering device including a sputtering target according to any embodiments of the present invention.

The magnetron sputtering device may comprise a vacuum chamber, preferably having metallic walls, in which the sputtering occurs. The rotatable sputtering target is held by a frame in the vacuum chamber via support blocks in such a way as to be rotatable about its longitudinal axis. A motor positioned outside the vacuum chamber enables the rotation of the sputtering target. The magnetron sputtering device may further comprise a support structure for supporting a substrate on which a sputtered film is to be deposited. For instance, the support structure may comprise rollers to allow the substrate to be passed through the vacuum chamber in a continuous process.

A vacuum can be drawn within the vacuum chamber by an appropriate pumping system. One or more gases may be provided by a supply to the vacuum chamber by a delivery system. A plasma may then be created within the vacuum chamber by applying a voltage from a power supply to the sputtering target surface which is negative with respect to the vacuum chamber walls, the support blocks or some other anode, which is usually connected to ground potential. The power supply is in electrical communication with the sputtering target, being connected thereto through an anode within the vacuum chamber, such as the support block. The plasma can be positioned adjacent to a sputtering zone of the cylindrical sputtering target, as controlled by the positioning of magnets. These magnets may be positioned along the length of the cylindrical sputtering target. The magnets are most conveniently held within the sputtering target by attachment to a coolant conduit. The coolant conduit may be provided as part of the target in a manner to be rotatable independently of the rotation of the target. Thus the position of the magnets in the target and the consequent position of the sputtering zone, may be controlled by rotation of the coolant conduit. In operation, the magnets may be non-rotatably held within the target to establish a stationary sputtering zone extending along a length of the target.

A cooling liquid supply and exhaust system may supply coolant in and exhaust heated coolant from the conduit. An electrical and electronic control system may operate to control the various parameters of the magnetron system being described.

Also, the present invention relates in a further aspect to a method of driving a magnetron sputtering device having a sputtering target according to any embodiments of the present invention, comprising the step of rotating the sputtering target in a plasma such as to sputter the sputter material to a substrate.

### Example 1:

In the present example a sputter target, according to an embodiment of the present invention, is manufactured_by means of the method of direct chill casting, according to an embodiment of the present invention at a casting speed v_{c} of 200 mm/min and a level hₗ of the liquid sputter material inside the mould of 170 mm. A mixture of mainly 85 mol% Zn and 15 mol% Sn is used as sputterable material. The liquid sputterable material enters the mould with a temperature of 500°C. The liquid sputter material is cast onto a metal carrier of stainless steel, which has an initial temperature of 50°C. The carrier is cylindrical and comprises an inner radius of 62.5 mm and an outer radius of 67 mm. The carrier is coated on its outer surface with a galvanised bonding layer with a thickness of 100 µm. The carrier is water-cooled on its inner surface. The outer surface of the target layer is water-jet cooled. The water-jet meets the target layer 2 mm below the mould base and runs on the outside of the sputter target downwards. The thickness of the target layer obtained is 20 mm. Under these conditions at least 80% of the grains of the sputter material comprises grains with an average diameter of less than 50 µm differing within a range Δd of Δd ≤ 50 µm. Further optimisation of the direct chill coating is expected to reduce Δd.

### Example 2: manufacturing of a sputter target

The present example is a method for manufacturing a sputter target according to an embodiment of the present invention by means of a method according to an embodiment of the present invention in a direct chill casting process. A casting speed v_{c} of 200 mm/min and a level hₗ of the liquid sputter material inside the mould of 30 mm is used. The mould had a total depth of 300 mm and is insulated with a liner on a depth of 180 mm. The direct chill mould running temperature is 50°C. A mixture of mainly 85 mol% Zn and 15 mol% Sn is used as sputter material. The liquid sputter material enters the mould with a temperature of 550°C. The liquid sputter material is cast onto a metal carrier of stainless steel of the 300 series, which is pre-heated at a temperature of 250°C. The carrier is tubular and comprises an inner radius of 125 mm and an outer radius of 133 mm. Its length is 800 mm. First, a degreasing pre-treatment is applied on the carrier. Then, the carrier is coated on its outer surface with a galvanised bonding Zn-layer with a thickness of 100 µm. Finally, the direct chill-casting of the third layer (sputter material) is performed. During this process, the carrier is water cooled on its inner surface. The outer surface of the target layer is water-jet cooled. The water-jet is meeting the target layer 2 mm below the mould base and is running on the outside of the sputter target downwards. The thickness of the target layer is 20 mm.

### Example 3: Comparative example

The sputter target obtained in example 2 was compared to a sputter target obtained via plasma thermal spraying. This comparative sputter target had as backing tube, a stainless steel tube of the 300 series having the same dimensions as that used in example 2. Its surface was pre-treated by gritblasting and a NiAI bond (second) layer was applied on the backing tube by plasma thermal spraying. The sputter material (third layer) was a mixture of mainly 85 mol% Zn and 15 mol% Sn. This third layer was applied via plasma thermal spraying.

The following table shows the difference in characteristics between the target of example 2 and the comparative target of example 3:

| | Example 2 | Example 3 (comparative) |
|---|---|---|
| density (buoyancy-flotation method) | 99,9 % of theoretical density | 94 % of theoretical density |
| thermal conductivity at 50 °C | 107 W/mK | 72 W/mK |
| specific heat at 25 °C (laser flash) | 0,361 J / g °C | 0,362 J / g °C |
| | | |
| purity (measured ICP trace > elements) % | 99,95 % | > 99,7% |
| oxygen concentration | 40 ppm | 600 - 800 ppm |
| nitrogen concentration | 5 ppm | 80 - 200 ppm |
| | | |
| Ultrasonic testing (indicative measure for bond quality and porosity) | Average Amplitude of reflection signal from inner diameter of layer 1: > 90 % | Average amplitude reflection signal from inner diameter of layer 1: > 75% |
| | | |
| sputter power @ 15 kW DC/m - Ar/O2 partial pressure (Bekaert DC magnetron); | > 35 kW DC/m | > 35 kW DC/m |

It appears from this comparison that the purity, the density and the thermal conductivity of the target obtained by the method of example 2 is surprisingly improved in comparison with the purity, the density and the thermal conductivity of the target obtained by plasma thermal spraying.

Other arrangements for accomplishing the objectives of the methods and devices embodying the invention will be obvious for those skilled in the art.

It is to be understood that although preferred embodiments, specific constructions and configurations, as well as materials, have been discussed herein for devices according to the present invention, various changes or modifications in form and detail may be made without departing from the scope of this invention as defined by the appended claims.

## Claims

1. A sputter target for use as a material source in a sputtering process, comprising a mainly tubular or cylindrical carrier for supporting at least one layer, and a target layer for providing sputter material supported by the carrier, wherein the target layer is a direct chill cast layer.

2. The sputter target according to claim 1, wherein in radial direction at least 80% of the grains of the sputter material (34) have a diameter differing within a range Δd of Δd ≤ 100 µm, particularly Δd ≤ 75 µm, preferably Δd ≤ 60 µm and most preferred Δd ≤ 40 µm.

3. A sputter target for use as a material source in a sputtering process, comprising
a mainly tubular or cylindrical carrier (22) for supporting at least one layer, a target layer (32) for providing sputter material (34) supported by the carrier (22),
wherein in radial direction at least 80% of the grains of the sputter material (34) have grain sizes differing in diameter within a range Δd of Δd ≤ 100 µm, particularly Δd ≤ 75 µm, preferably Δd ≤ 60 µm and most preferred Δd ≤ 40 µm.

4. The sputter target according to claim 2 or claim 3, wherein at least 80%, particularly 85%, preferably at least 90% and most preferred at least 95% of the grains of the sputter material (34) in radial direction have an average diameter d of d = 60 µm ± Δd, particularly d = 50 µm ± Δd, preferably d = 40 µm ± Δd and most preferred d = 30 µm ± Δd, wherein Δd < d is given.

5. The sputter target according to any one of claims 1 to 4, wherein a bonding layer (24), optionally comprising one or more sub-layers for bonding the target layer (32) to the carrier (22) is provided between the carrier (22) and the target layer (32).

6. A method for manufacturing a sputter target (12), particularly according to anyone of claims 1 to 5, wherein
a direct chill casting process is applied for providing a mainly tubular or cylindrical carrier (22) with a target layer (32) for providing sputter material,
wherein a casting speed v_{c} of the relative movement of a mould (14) comprising liquid sputter material (20) to the carrier (22) and a level hₗ of the liquid sputter material (20) inside the mould in axial direction of the carrier (22) is chosen such that at least 80% of the grains of the sputter material (34) comprises in solidified state in radial direction grains having a diameter differing within a range Δd of Δd ≤ 100 µm, particularly Δd ≤ 75 µm, preferably Δd ≤ 60 µm and most preferred Δd ≤ 40 µm.

7. Method according to claim 6, wherein the sputter material (20, 34) is liquid-jet cooled at the level and/or below the mould (14), wherein a cooling area, where the liquid-jet (26) meets the sputter material (20, 34), and a mass flow of a used liquid, particularly water, is chosen with respected to the intended grain sizes of the sputter material (34).

8. The method according to claim 6 or claim 7, wherein a temperature Tₗ of the liquid sputter material (20) filled into the mould (14) and/or a Temperature T_{ci} of the carrier (22) on the inside is chosen with respect to the intended grain sizes of the sputter material (34).

9. The method according to anyone of claim 6 to 8, wherein the carrier (22) is coated with a bonding layer (24) for bonding the target layer (32) to the carrier (22) and the thickness of the bonding layer (24) in radial direction is chosen such that at given casting speed v_{c} and level hₗ of the liquid sputter material (20) a residual thickness of the bonding layer (24) remains present in solidified state of the sputter material (34).

10. Method according to anyone of claims 6 to 9, wherein the casting speed v_{c} is 1 mm/min ≤ v_{c} ≤ 30 mm/min, particularly 2 mm/min ≤ v_{c} ≤ 20 mm/min, preferably 3 mm/min ≤ v_{c} ≤ 10 mm/min and most preferred 4 mm/min ≤ v_{c} ≤ 5 mm/min.

11. The method according to any one of claims 6 to 10, wherein the level hₗ of the liquid sputter material (20) is 40 mm ≤ hₗ ≤ 400 mm, particularly 60 mm ≤ hₗ ≤ 320 mm, preferably 80 mm ≤ hₗ ≤ 280 mm and most preferred 100 mm ≤ hₗ ≤ 240 mm.

12. The method according to any one of claims 6 to 11, wherein an outside of the liquid sputter material (20) is cooled by such a cooling rate that a temperature difference of ΔT_{c} = 100 K is reached after a cooling time t_{c} of 20 s ≤ t_{c} ≤ 150 s, particularly 30 s ≤ t_{c} ≤ 100 s, preferably 40 s ≤ t_{c} ≤ 70 s and most preferred 50 s ≤ t_{c} ≤ 60 s.

13. An apparatus for direct chill casting, particularly for carrying out the method according to anyone of claims 6 to 12, comprising a support device for supporting a mainly tubular or cylindrical carrier (22) for supporting at least one layer,
a mould (14) for receiving a liquid sputter material (20) and casting the liquid sputter material (20) onto the carrier (22), wherein the mould (14) is adapted for providing at least a level hₗ of the liquid sputter material (20) inside the mould (14) in axial direction of the carrier (22), a melting furnace and melt launder to feed the molten metal into the pouring basin above the mould, an inert gas or vacuum system for protecting the melt from oxidation ,an insulation system for mould and pouring basin , a "level pour" system for ensuring constant liquid level during the direct chill casting process, and
a controller for controlling a casting speed v_{c} of the relative movement of the mould (14) to the carrier (22) and the level hₗ of the liquid sputter material (20) such that at least 80% of the grains of the sputter material (34) comprises in solidified state in radial direction grains having a diameter differing within a range Δd of Δd ≤ 100 µm, particularly Δd ≤ 75 µm, preferably Δd ≤ 60 µm and most preferred Δd ≤ 40 µm.

14. A magnetron-sputtering device including a sputtering target according to any of the claims 1 to 5.

15. A method of driving a magnetron sputtering device having a sputtering target according to any of the claims 1 to 5, comprising the step of:
rotating the sputtering target in a plasma such as to sputter the sputter material to a substrate.
